(19) Europäisches Patentamt
European Patent Office
Office européen des brevets

(11) **EP 4 019 267 A1**

(12) **EUROPEAN PATENT APPLICATION**
published in accordance with Art. 153(4) EPC

(43) Date of publication:
**29.06.2022 Bulletin 2022/26**

(21) Application number: **20858014.2**

(22) Date of filing: **01.07.2020**

(51) International Patent Classification (IPC):
**B41N 1/12** *(2006.01)*   **B41C 1/00** *(2006.01)*
**B41M 1/04** *(2006.01)*   **G03F 7/00** *(2006.01)*
**G03F 7/027** *(2006.01)*   **G03F 7/031** *(2006.01)*
**G03F 7/095** *(2006.01)*

(52) Cooperative Patent Classification (CPC):
**B41C 1/00; B41M 1/04; B41N 1/12; G03F 7/00;**
**G03F 7/027; G03F 7/031; G03F 7/095**

(86) International application number:
**PCT/JP2020/025896**

(87) International publication number:
**WO 2021/039106 (04.03.2021 Gazette 2021/09)**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **23.08.2019   JP 2019152850**

(71) Applicant: TOYOBO CO., LTD.
**Osaka-shi**
**Osaka 5300001 (JP)**

(72) Inventors:
• **YOSHIMOTO, Kazuya**
**Okayama 704-8194 (JP)**
• **HIGO, Eri**
**Shiga 520-0292 (JP)**
• **NAKAMORI, Masahiko**
**Okayama 704-8194 (JP)**

(74) Representative: **Müller-Boré & Partner**
**Patentanwälte PartG mbB**
**Friedenheimer Brücke 21**
**80639 München (DE)**

(54) **FLEXOGRAPHIC PRINTING PLATE**

(57)    The present invention provides a flexographic printing plate which is capable of achieving both of the reduction in dot gain of fine dots and satisfactory ink laydown on a solid-printed part. A flexographic printing plate obtained from a flexographic printing plate precursor comprising at least a support (A) , a photosensitive resin layer (B) and a heat-sensitive mask layer (C) which are laminated in this order, characterized in that the composite elastic modulus of each dot is 30 to 80 Mpa and the composite elastic modulus of each solid-printed part is 5 to 15 MPa. A photosensitive resin composition constituting the photosensitive resin layer (B) comprises (a) a polymer prepared by polymerizing a conjugated diene, (b) an ethylenically unsaturated compound and (c) a photopolymerization initiator, wherein the content of the photopolymerization initiator (c) in the photosensitive resin composition is 2 to 9% by mass, wherein the ethylenically unsaturated compound (b) includes a (meth)acrylate compound (i) having a number average molecular weight of 100 to 600, wherein the content of the compound (i) in the photosensitive resin composition is 5 to 16% by mass, and wherein the ratio of the mass of the photopolymerization initiator (c) and the mass of the compound (i) in the photosensitive resin composition is within the range of 0.20 to 0.55.

EP 4 019 267 A1

**Description**

Technical Field

The present invention relates to a flexographic printing plate which is capable of achieving both of the reduction in dot gain of fine dots and satisfactory ink laydown on a solid-printed part.

Background Art

Flexographic printing is a printing method in which an ink is applied onto convex parts on a printing plate and then the printing plate is pressed against a substrate so as to transfer the ink from the printing plate to the substrate. A printing plate used in flexographic printing is relatively soft and can fit to various shapes, and therefore makes it possible to print on wide varieties of substrates. Examples of the substrate include a packaging film, label paper, drink carton, a paper-made container, an envelope and cardboard. Particularly for a substrate having a rough surface, flexographic printing is mainly employed. Furthermore, flexographic printing can utilize a water-based or alcohol-based ink from which the emission amount of VOCs (volatile organic compounds) is small. Therefore, flexographic printing is a highly environment-friendly printing method. Due to the above-mentioned advantages, i.e., the adaptability to substrates and the environmental friendliness, gravure printing and offset printing are increasingly shifting to flexographic printing.

In flexographic printing, however, a relatively soft printing plate is pressed against a substrate for printing. Therefore, the printing plate is deformed upon the pressing and the phenomenon (dot gain) that the size of each printed dot becomes larger than the size of each dot on the printing plate occurs. This dot gain phenomenon occurs prominently with the reduction of the size of the dots. This is because the reduction of the size of the dots causes the larger amount of deformation of printed dots due to pressing pressure. In flexographic printing, remarkably larger dot gain occurs compared with gravure printing and offset printing in which a hard printing plate is used. The dot gain of fine dots can be reduced by decreasing the pressing pressure. In this case, however, the transfer of an ink on a solid-printed part becomes insufficient, and remarkable deterioration in quality, e.g, the undersupply of an ink, on a solid-printed part may occur.

Heretofore, as to a method for reducing dot gain, a method in which the dynamic hardness of dots is increased has been proposed (see Patent Document 1). In Patent Document 1, a polyfunctional crosslinkable monomer is added to a photosensitive resin layer so as to increase the crosslinking density, thereby improving the dynamic hardness of the dots. However, when the crosslinking density is increased in this way, the printing plate is wholly hardened and the ink laydown performance on a solid-printed part becomes insufficient.

In order to solve this problem, a method which aims to satisfy both of the dynamic hardness of dots and the dynamic hardness of a solid-printed part has been proposed (see Patent Document 2). In Patent Document 2, attention is focused on the chemical structure of a crosslinking agent used in a photosensitive resin layer. Specifically, it is proposed to use a crosslinking agent having at least two methacrylate or acrylate groups in which the ratio of the methacrylate groups is 50% or more. In this method, however, the ratio of the dynamic hardness of a dot to the dynamic hardness of a solid-printed part is within a range of 0.6 to 1.0. In other words, a solid-printed part is harder than a dot part, and therefore both of the reduction of dot gain of fine dots and the satisfactory ink laydown on a solid-printed part cannot be achieved.

There have been proposed another methods which aims to achieve both of the dynamic hardness of a dot surface and the dynamic hardness of an inside part (see Patent Document 3). Patent Document 3 is characterized in that a conjugated diene oligomer having a 1,2-butadiene backbone and having no crosslinking group is added to a photosensitive resin layer. In Patent Document 3, the dynamic hardness of an inside part is reduced and the attachability of a printing plate is improved by using a material having no crosslinking group. In this method, although the dynamic hardness of an inside part can be reduced, the dynamic hardness of a solid-printed part cannot be reduced and therefore the ink laydown on the solid-printed part is insufficient. In addition, by adding a material having no crosslinking group, the hardness of fine dots is decreased, leading to the occurrence of dot gain of fine dots.

On the other hand, an example of a common flexographic printing plate is disclosed in Patent Document 4. A photosensitive resin layer in a flexographic printing plate disclosed in Patent Document 4 is characterized by including (A) a hydrophobic polymer obtained from a water-dispersible latex, (B) a hydrophilic polymer, (C) a photopolymerizable unsaturated compound, and (D) a photopolymerization initiator, in which (C-1) a photopolymerizable oligomer containing no hydroxyl group, (C-2) a photopolymerizable monomer containing a hydroxyl group and (C-3) a photopolymerizable monomer containing no hydroxyl group are used as the photopolymerizable unsaturated compound (C). In the flexographic printing plates produced in Examples in Patent Document 4, the undersupply of an ink in printing and printing durability are improved. However, these printing plates cannot achieve both of the reduction of dot gain of fine dots and the satisfactory ink laydown on solid-printed parts.

Therefore, in these situations of the prior art, a flexographic printing plate which is capable of achieving both of the reduction in dot gain of fine dots and satisfactory ink laydown on a solid-printed part are strongly demanded.

Prior Art Documents

Patent Documents

Patent Document 1: Japanese Patent Application Laid-Open (JP-A) No. 80743/97
Patent Document 2: Japanese Patent Application Laid-Open (JP-A) No. 2000-221663
Patent Document 3: Japanese Patent Application Laid-Open (JP-A) No. 2002-62639
Patent Document 4: Japanese Patent No. 607962

Disclosure of the Invention

Problem that the Invention is to Solve

The present invention is made in these situations of the prior art. The object of the present invention is to provide a flexographic printing plate which is capable of achieving both of the reduction in dot gain of fine dots and satisfactory ink laydown on a solid-printed part.

Means for Solving the Problem

In order to achieve the above-mentioned object, the present inventors have made extensive and intensive studies. As a result, it has been found that, in a printing plate, the pressure applied to a dot during printing process is larger than that applied to a solid-printed part during printing process. Therefore it is desirable that the dot is harder than the solid-printed part. The present inventors have also further examined about specific parameters for the evaluation of hardness. As a result, it has been found that: when dynamic hardness which has been employed in the prior art techniques is employed as the parameter, measurement accuracy is generally poor and elastic deformation cannot be examined; while when a composite elastic modulus is employed as the parameter, these disadvantages do not occur. The present inventors have found that, in order to achieve both of the reduction in dot gain of fine dots and the satisfactory ink laydown in a solid-printed part, it is required to adjust the composite elastic modulus of each of dots to a specific higher value and also adjust the composite elastic modulus of a solid-printed part to a specific lower value. And it has also been found that the object of the present invention can be achieved by the following countermeasures: (a) a photopolymerization initiator is added in a larger amount compared with the conventional flexographic printing plate, in a photosensitive resin composition constituting a photosensitive resin layer, an ethylenically unsaturated compound having a low molecular weight is added in a specified amount as an ethylenically unsaturated compound component in the photosensitive resin composition, and the ratio of the mass of the photopolymerization initiator to the mass of the ethylenically unsaturated compound having a low molecular weight is adjusted to a higher value compared with the conventional flexographic printing plate; (b) as to the ethylenically unsaturated compound component in the photosensitive resin composition, an ethylenically unsaturated compound having a high molecular weight is added in addition to the ethylenically unsaturated compound having a low molecular weight; (c) as to a photopolymerization initiator component, specific two types of photopolymerization initiators are used; and (d) an oxygen barrier layer is provided between the photosensitive resin layer and a mask layer. Based on these findings, the present invention has been accomplished.

In summary, the present invention has the following configurations (1) to (7).

(1) A flexographic printing plate obtained from a flexographic printing plate precursor comprising at least a support (A), a photosensitive resin layer (B) and a heat-sensitive mask layer (C) which are laminated in this order, characterized in that the composite elastic modulus of each dot is 30 to 80 Mpa and the composite elastic modulus of each solid-printed part is 5 to 15 MPa.

(2) The flexographic printing plate according to (1), wherein a photosensitive resin composition constituting the photosensitive resin layer (B) comprises (a) a polymer prepared by polymerizing a conjugated diene, (b) an ethylenically unsaturated compound and (c) a photopolymerization initiator, wherein the content of the photopolymerization initiator (c) in the photosensitive resin composition is 2 to 9% by mass, wherein the ethylenically unsaturated compound (b) includes a (meth)acrylate compound (i) having a number average molecular weight of 100 to 600, wherein the content of the (meth)acrylate compound (i) having a number average molecular weight of 100 to 600 in the photosensitive resin composition is 5 to 16% by mass, and wherein the ratio of the mass of the photopolymerization initiator (c) and the mass of the (meth)acrylate compound (i) having a number average molecular weight of 100 to 600 in the photosensitive resin composition is within the range of 0.20 to 0.55.

(3) The flexographic printing plate according to (2), wherein the ethylenically unsaturated compound (b) further includes a (meth)acrylate compound (ii) having a number average molecular weight of more than 600 and not more than 20,000, and wherein the content of the (meth)acrylate compound (ii) having a number average molecular weight of more than 600 and not more than 20,000 in the photosensitive resin composition is 5 to 25% by mass.

(4) The flexographic printing plate according to (2) or (3), wherein the photopolymerization initiator (c) includes two types of compounds which are a benzyl alkyl ketal compound and a benzophenone compound, and wherein the ratio of the mass of the benzyl alkyl ketal compound to the mass of the benzophenone compound is within the range of 99:1 to 80:20.

(5) The flexographic printing plate according to any of (1) to (4), wherein the flexographic printing plate precursor has an oxygen barrier layer (D) between the photosensitive resin layer (B) and the heat-sensitive mask layer (C).

(6) The flexographic printing plate according to any of (1) to (5), wherein the flexographic printing plate has been obtained by developing the flexographic printing plate precursor using a water-based developing solution.

(7) A flexographic printing method, characterized in that the method uses the flexographic printing plate according to any of (1) to (6).

Advantages of the Invention

In the flexographic printing plate according to the present invention, the dot gain of fine dots can be reduced because the composite elastic modulus of each dot is adjusted to a specific higher value. In addition, in the flexographic printing plate according to the present invention, an ink laydown on a solid-printed part is excellent because the composite elastic modulus of the solid-printed part is adjusted to a specific lower value. Therefore, the flexographic printing plate according to the present invention can achieve both of the reduction in dot gain in fine dots and the satisfactory ink laydown on a solid-printed part.

Best Mode for Carrying Out the Invention

The flexographic printing plate according to the present invention is a flexographic printing plate obtained from a flexographic printing plate precursor comprising at least a support (A), a photosensitive resin layer (B) and a heat-sensitive mask layer (C) which are laminated in this order. Specifically, the flexographic printing plate according to the present invention is a printing plate obtained by exposing and developing such a flexographic printing plate precursor. The flexographic printing plate according to the present invention is characterized in that the composite elastic modulus of each dot is adjusted to a specific higher value and the composite elastic modulus of each solid-printed part is adjusted to a specific lower value. By constituting the composite elastic modulus of each dot and the composite elastic modulus of each solid-printed part in such a manner, the flexographic printing plate according to the present invention can achieve both of the prevention of dot gain in fine dots and the satisfactory ink laydown on a solid-printed part.

The (A) support used in flexographic printing plate precursor is preferably made from a material being flexible and having a superior dimension stability. Examples thereof include: a support made of metal, such as steel, aluminum, copper and nickel, and a support made of a thermoplastic resin, such as a polyethylene terephthalate film, a polyethylene naphthalate film, a polybutylene terephthalate film and a polycarbonate film. Among these, the polyethylene terephthalate film, which has the superior dimension stability and a sufficiently high viscoelasticity, is in particular preferably used. A thickness of the support is set to 50 to 350 μm, preferably, to 100 to 250 μm, from viewpoints of mechanical properties, shape stability and handling characteristics during manufacturing of a printing plate. Moreover, if necessary, an adhesive may be arranged between the support (A) and the photosensitive resin layer (B) in order to improve an adhesive property between them.

The photosensitive resin composition constituting the photosensitive resin layer (B) used in flexographic printing plate precursor comprises (a) a polymer prepared by polymerizing a conjugated diene, (b) an ethylenically unsaturated compound and (c) a photopolymerization initiator, and if necessary, comprises an additive such as a plasticizer, a hydrophilic compound, an ultraviolet ray absorber, a surface tension modulator, a thermal polymerization inhibitor, a dye, a pigment, a flavoring agent, and an antioxidant agent. The present invention is particularly characterized in that: in the photosensitive resin composition constituting the photosensitive resin layer (B), the composition of the ethylenically unsaturated compound (b) is specifically designed; and the photopolymerization initiator (c) is used at a mass-based ratio that is larger than the ratio actually employed in the conventional techniques.

As to the polymer prepared by polymerizing the conjugated diene (a), a conventional known synthetic high-molecular-weight compound that has been used in a printing plate precursor can be used. Examples of the polymer include a polymer prepared by polymerizing a conjugated diene hydrocarbon and a copolymer prepared by copolymerizing a conjugated diene hydrocarbon and a monoolefin unsaturated compound. Specific examples of the polymer include a butadiene polymer, an isoprene polymer, a chloroprene polymer, a styrene-butadiene copolymer, a styrene-butadiene-styrene copolymer, a styrene-isoprene copolymer, a styrene-isoprene-styrene copolymer, a styrene-chloroprene copolymer, an acrylonitrile-butadiene copolymer, an acrylonitrile-isoprene copolymer, a (methyl methacrylate)-butadiene copolymer, a (methyl methacrylate)-isoprene copolymer, an acrylonitrile-butadiene-styrene copolymer, and an acrylonitrile-isoprene-styrene copolymer. Among these polymers, a butadiene polymer is preferably used, from the viewpoint of the properties of flexographic printing plates, i.e., repulsion elasticity of a surface of a printing plate, high elongation properties, resin plate hardness, dimensional stability during unexposed state, and easy availability. These polymers may be used singly, or two or more of them may be used in combination. It is preferred that the content of the component (a) in the photosensitive resin composition that forms the photosensitive resin layer (B) is within the range of 40 to 70% by mass.

As to the ethylenically unsaturated compound (b), a conventional known one that has been used in a printing plate precursor can be used. It is preferred to include a (meth)acrylate compound having a number average molecular weight of 100 to 600 (hereinafter, it may be simply referred to as a (meth)acrylate compound having a low molecular weight) (i). In addition, it is preferred to further include a (meth)acrylate compound having a number average molecular weight of more than 600 and not more than 20,000 (hereinafter, it may be simply referred to as a (meth)acrylate compound having a high molecular weight) (ii). The (meth)acrylate compound having a low molecular weight is crosslinked and cured by the action of a photopolymerization initiator so as to form a dense crosslinked network. The (meth)acrylate compound having a high molecular weight is crosslinked and cured by the action of the photopolymerization initiator so as to form a loose crosslinked network. The number average molecular weight of the former is further preferably 200 to 500, and that of the latter is further preferably 2000 to 10000. As mentioned above, when not only the (meth)acrylate compound having a low molecular weight but also the (meth)acrylate compound having a high molecular weight are contained, the reproducibility of isolated dots and durability during printing cannot be deteriorated even when the photopolymerization initiator (c) is added in a larger amount compared with the conventional flexographic printing plate. This is supposed to be because the toughness of the printing plate is increased by the addition of the (meth)acrylate compound having a high molecular weight in a specified amount. It is preferred that the content of the component (b) in the photosensitive resin composition that forms the photosensitive resin layer (B) is within the range of 10 to 50% by mass.

The content of the (meth)acrylate compound having a high molecular weight in the photosensitive resin composition is preferably 5 to 25% by mass and further preferably 8 to 20% by mass. If the content is less than the above-mentioned range, the durability may be deteriorated when the photopolymerization initiator (c) is added in a larger amount. If the content is more than the above-mentioned range, the composite elastic modulus of a solid-printed part may be increased. The content of the (meth)acrylate compound having a low molecular weight in the photosensitive resin composition is preferably 5 to 16% by mass and further preferably 7 to 13% by mass. By adding the (meth)acrylate compound having a low molecular weight in an amount within the above-mentioned range, the effect to selectively improve the composite elastic modulus of the dots can be increased. However, if the content is less than the above-mentioned range, the effect to selectively improve the composite elastic modulus of the dots is insufficient. When the content is more than the above-mentioned range, the composite elastic modulus of the solid-printed part may be increased.

The (meth)acrylate compound having a low molecular weight is not particularly limited, as long as the number average molecular weight of the compound is within the range of 100 to 600 inclusive. Examples of the compound include liner, branched or cyclic monofunctional monomers such as hexyl (meth)acrylate, nonane (meth)acrylate, lauryl (meth)acrylate, stearyl (meth)acrylate, 2-ethyl, 2-butylpropanediol (meth)acrylate, hydroxyethyl (meth)acrylate, 2-(meth)acryloyloxyethyl hexahydrophtalate, 2-(meth)acryloyloxyethyl phtalate, a (meth)acrylic acid dimer, ECH denatured allyl acrylate, benzyl acrylate, caprolactone (meth)acrylate, dicyclopentenyl (meth)acrylate, isobornyl (meth)acrylate and cyclohexyl (meth)acrylate. The examples also include linear branched or cyclic polyfunctional monomers such as hexanediol di(meth)acrylate, nonanediol di(meth)acrylate, 2-butyl-2-ethylpropanediol di(meth)acrylate, neopentyl glycol di(meth)acrylate, neopentylglycol hydroxypivalate di(meth)acrylate, ECH denatured phthalic acid di(meth)acrylate, dicyclopentadiene di(meth)acrylate, tricyclodecanedimethanol di(meth)acrylate, trimethylolpropane tri(meth)acrylate, pentaerythritol tri(meth)acrylate, ECH denatured glycerol tri(meth)acrylate, trimethylolpropane benzoate (meth)acrylate, EO(PO) denatured trimethylolpropane tri(meth)acrylate and dipentaerythritol hexa(meth)acrylate. These compounds may be used singly. Alternatively, two or more of them may be used in combination for the purpose of imparting a desired resin property.

The (meth)acrylate compound having a high molecular weight is not particularly limited, as long as the number average molecular weight of the compound is within the range of more than 600 and not more than 20,000. For example, a butadiene oligomer or an isoprene oligomer each having a (meth)acrylate group attached thereto, and urethane(meth)acrylate are also exemplified. These compounds may be used singly. Alternatively, two or more of them may be used in combination for the purpose of imparting a desired resin property.

The ratio of the mass of the photopolymerization initiator (c) and the mass of the (meth)acrylate compound (i) having a low molecular weight [(mass of the photopolymerization initiator)/(mass of the (meth)acrylate compound having a low molecular weight)] is preferably 0.20 to 0.55. It is more preferably 0.22 to 0.50 and further preferably 0.25 to 0.45. By adjusting the ratio as mentioned above, the requirement for the composite elastic modulus of the dots can be fully satisfied. If the ratio is less than the above-mentioned range, the amount of the photopolymerization initiator is too small, and therefore the effect to selectively improve the composite elastic modulus of the dots may be deteriorated. If the ratio is more than the above-mentioned range, the amount of the photopolymerization initiator becomes too much in relation to the amount of the (meth)acrylate, and consequently the amount of the (meth)acrylate required for causing the crosslinking reaction may be insufficient. In this case, the effect to selectively improve the composite elastic modulus of the dots may be insufficient.

Examples of the photopolymerization initiator (c) include a benzophenone compound, a benzoin compound, an acetophenone compound, a benzyl compound, a benzoin alkyl ether compound, a benzyl alkyl ketal compound, an anthraquinone compound and a thioxanthone compound. More specific examples include benzophenone, chlorobenzophenone, benzoin, acetophenone, benzyl, benzoin methyl ether, benzoin ethyl ether, benzoin isopropyl ether, benzoin isobutyl ether, benzyl dimethylketal, benzyl diethylketal, benzyl diisopropylketal, anthraquinone, 2-ethylanthraquinone, 2-methylanthraquinone, 2-allylanthraquinone, 2-chloroanthraquinone, thioxanthone and 2-chlorothioxanthone.

The photopolymerization initiator (c) preferably includes two types of compounds which consist of a benzyl alkyl ketal compound and a benzophenone compound. The ratio of the mass of the benzyl alkyl ketal compound to the mass of the benzophenone compound is preferably within the range of 99:1 to 80:20 and further preferably within the range of 97:3 to 85:15. The photopolymerization initiator has an intrinsic optical absorption spectrum. Therefore, by using two types of photopolymerization initiators in combination, it becomes possible to efficiently utilize the optical energy of the below-mentioned finishing exposure and the exposure using a germicidal lamp. Particularly when two types of photopolymerization initiators are a benzyl alkyl ketal compound and a benzophenone compound, the composite elastic modulus of each dot can be further improved selectively. As to the benzyl alkyl ketal compound, benzyl dimethylketal is preferred. As to the benzophenone compound, benzophenone is preferred. Particularly benzophenone does not have optical absorption to a lamp to be used in the main exposure (peak wavelength: 370 nm), but has optical absorption to a lamp of a germicidal lamp (peak wavelength: 250 nm). Therefore, the composite elastic modulus of each dot can be improved selectively only by the exposure with a germicidal lamp, without increasing the composite elastic modulus of each solid-printed part with the main exposure light.

In the present invention, the content of the photopolymerization initiator (c) in the photosensitive resin composition is preferably 2 to 9% by mass, more preferably 2.5 to 7.5% by mass, and further preferably 3 to 7% by mass. As mentioned above, the increase in the content of the photopolymerization initiator to a larger amount compared with the conventional flexographic printing plate can contribute to the selective improvement of the composite elastic modulus of each dot without changing the composite elastic modulus of each solid-printed part. Conventionally, it has been believed that, when the content of a photopolymerization initiator is increased, the reach of light in the thickness direction of a printing plate is blocked due to the absorption of light by the photopolymerization initiator after the reaction to thereby deteriorate the reproducibility of isolated dots and deteriorate the durability during printing. For these reasons, conventionally, the content of a photopolymerization initiator in a photosensitive resin composition of about 1% by mass at most has been generally employed in the actual practice. In contrast, in the present invention, by adding a (meth)acrylate compound having a high molecular weight in a specified amount in the photosensitive resin composition, it becomes possible to increase the toughness of a printing plate and to thereby overcome the above-mentioned disadvantages of prior arts (deterioration of reproducibility of isolated dots and deterioration of durability during printing) which occur when a photopolymerization initiator is used in a large amount, and therefore utilize benefit (selective improvement in the composite elastic modulus of the dots) from the increase in the content of the photopolymerization initiator.

The photosensitive resin composition constituting the photosensitive resin layer (B) used in flexographic printing plate precursor comprises, in addition to (a) a polymer prepared by polymerizing a conjugated diene, (b) an ethylenically unsaturated compound and (c) a photopolymerization initiator, an additive such as a plasticizer, a hydrophilic compound, an ultraviolet ray absorber, a surface tension modulator, a thermal polymerization inhibitor, a dye, a pigment, a flavoring agent, and an antioxidant agent, depending on necessity.

The plasticizer is used for imparting flexibility to the photosensitive resin layer (B) . Examples of the plasticizer include a liquid rubber, an oil, a polyester, and a phosphorus-based compound. Examples of the liquid rubber include liquid polybutadiene, liquid polyisoprene, and a compound prepared by adding a hydroxyl group or a carboxyl group to each of these compounds. Examples of the oil include paraffin, naphthene and an aroma oil. An example of the polyester is an adipic acid-based polyester. An example of the phosphoric acid-based compound is a phosphoric acid ester. Among these compounds, a liquid polybutadiene and a liquid polybutadiene having a hydroxyl group or a carboxyl group attached thereto are preferred from the viewpoint of compatibility with the polymer prepared by polymerizing a conjugated diene. When the development is performed with a water-based developing solution, a liquid polybutadiene having a hydroxyl group or a carboxyl group attached thereto is particularly preferred. The content of the plasticizer in the photosensitive resin composition is preferably 5 to 15% by mass.

The hydrophilic compound is used for improving the developability of the photosensitive resin layer (B) with the water-based developing solution. Examples of the hydrophilic compound include a carboxylic acid, a carboxylic acid salt, a sulfonic acid, a sulfonic acid salt, an acrylic polymer having a hydrophilic group (e.g., a hydroxyl group, an amino group, a phosphate group, an ethylene oxide group, a propylene oxide group), a urethane polymer, a polyamide polymer, and a polyester polymer. In addition, a known surfactant may also be used. Among these compounds, a urethane polymer having a carboxylate group is preferred from the viewpoint of the developability in a water-based developing solution. The content of the hydrophilic compound in the photosensitive resin composition is preferably 1 to 15% by mass.

The surface tension modifier is used for modifying the surface tension of a printing plate. By modifying the surface tension of a printing plate, the ink transfer properties and the clogging with an ink on a printing plate can be modified. Examples of the surface tension modifier include a paraffin oil, a long-chain alkyl compound, a surfactant, a fatty acid amide, a silicone oil, a modified silicone oil, a fluorine compound, and a modified fluorine compound. The content of the surface tension modifier in the photosensitive resin composition is preferably 0.1 to 2% by mass.

The ultraviolet ray absorber is used for improving the exposure latitude of the photosensitive resin layer (B). Examples of the ultraviolet ray absorber include a benzophenone-based compound, a salicylate-based compound, a benzotriazole-based compound, an acrylonitrile-based compound, a metal complex salt-based compound, a hindered amine-based compound, an anthraquinone-based compound, an azo-based compound, a coumarin-based compound, and a furan-based compound. Among these compounds, a benzotriazole-based compound is preferred from the viewpoint of easy availability and exposure latitude. The content of the ultraviolet ray absorber in the photosensitive resin composition is preferably 0.005 to 0.1% by mass.

In general, when a flexographic printing plate is produced from a flexographic printing plate precursor, four types of exposure, i.e., back exposure, main exposure, finishing exposure and the exposure with a germicidal lamp, are performed. Back exposure is performed for irradiating the whole area with light from the support side so as to form a floor part on the printing plate. Main exposure is performed for imagewise-irradiating a flexographic printing plate precursor with light through a mask and then crosslinking and curing an unsaturated compound in a light-irradiated part on the photosensitive resin layer, thereby forming an area that will become an image. Finishing exposure is performed for irradiating, with light, the whole are of the printing plate which has been developed after the main exposure and now has convex parts that correspond to the dot part and solid-printed parts formed thereon. The role of finishing exposure is to compensate the insufficient crosslinking and curing by the main exposure and to crosslink and cure side surfaces of the convex of the dot part. Exposure with a germicidal lamp is performed for removing the surface stickiness of the printing plate, and partially has a role of crosslinking and curing of side surfaces of the convex of the dot part, similar to the finishing exposure. In general, each of main exposure and finishing exposure is performed utilizing UVA, while exposure with a germicidal lamp is performed utilizing UVC.

The curing of side surfaces of dots by the finishing exposure and the exposure with a germicidal lamp has occurred to some extent in the conventional flexographic printing plate. The finishing exposure and the exposure with a germicidal lamp are generally performed under atmosphere. Therefore, polymerization is inhibited by the action of oxygen in the atmosphere. Therefore, in the conventional flexographic printing plate, the level of the curing of side surfaces of dots by the finishing exposure and the exposure with a germicidal lamp is not so high. In the present invention, in contrast, the influence of the polymerization inhibition by oxygen can be reduced satisfactorily and the side surfaces of dots can be cured sufficiently by adding the photopolymerization initiator in a larger amount compared with the conventional flexographic printing plate. As a result, the composite elastic modulus of dots can be improved significantly. The solid-printed parts have no side surface. Therefore, the composite elastic modulus of the solid-printed part is not changed to a large extent before and after the finishing exposure and the exposure with a germicidal lamp. In the present invention, the composite elastic modulus of each dot is larger than that of each solid-printed part. This is supposed to be because the side surfaces of dots are cured sufficiently and, as a result, the deformation of the dots can be prevented by means of the side surfaces, leading to the increase in the composite elastic modulus of each dot compared with that of each solid-printed part.

If the content of the photopolymerization initiator is smaller than the above-mentioned preferred range, the effect to increase the composite elastic modulus of each dot by the finishing exposure and the exposure with a germicidal lamp is small, and thus the composite elastic modulus of each dot becomes smaller than the range defined in the present invention. Consequently the dot gain of fine dots tends to occur. If the content of the photopolymerization initiator is more than the above-mentioned preferred range, on the other hand, the curing upon the main exposure proceeds and as a result, the composite elastic modulus of the solid-printed part becomes too high and the ink laydown on solid-printed parts tends to be deteriorated.

As to the heat-sensitive mask layer (C) used in the flexographic printing plate precursor, any conventional one which has been used in a printing plate precursor can be used. For example, the heat-sensitive mask layer is preferably composed of carbon black (which is a material having the function to absorb infrared ray laser so as to convert the absorbed infrared ray laser to heat and the function to block ultraviolet ray), a dispersion binder for carbon black, and a binder polymer capable of forming a coating film. The dispersion binder may double with the binder polymer capable of forming a coating film. Furthermore, an auxiliary component other than the above-mentioned components, e.g., a pigment dispersing agent, a filler, a surfactant and a coating aid, may be contained, as long as the effects of the present invention cannot be deteriorated.

The heat-sensitive mask layer (C) used in the flexographic printing plate precursor of the present invention is preferably developable with water. Examples of the heat-sensitive mask layer (C) include: a heat-sensitive mask layer containing a combination of a polyamide containing a polar group and a butyral resin (Japanese Patent No. 4200510); a heat-sensitive mask layer containing a polymer having the same structure as that of the polymer in the photosensitive resin layer and an acrylic resin (Japanese Patent No. 5710961); and a heat-sensitive mask layer containing an anionic polymer and a polymer having an ester group in a side chain thereof and having a saponification degree of 0 to 90% inclusive (Japanese Patent No. 5525074).

Preferably, the flexographic printing plate precursor of the present invention is provided with an oxygen barrier layer (D) between the photosensitive resin layer (B) and the heat-sensitive mask layer (C). When an oxygen barrier layer (D) is provided, the oxygen-induced polymerization inhibition during main exposure can be inhibited, and a satisfactory curing reaction can occur in both of the dot part and the solid-printed part. In this manner, a flat top suitable for printing is formed on the dot part. As the result of the formation of the flat top on each dot, the printing dot gain of fine dots is improved. Furthermore, the surface of each solid-printed part becomes smooth and consequently the ink laydown on the solid-printed parts is improved. Examples of the binder polymer in the barrier layer include polyvinyl alcohol, partially saponified polyvinyl acetate, an alkyl cellulose, a cellulose-based polymer, and polyamide. These polymers may not be always used singly, or a combination of two or more of these polymers may be used. Examples of the binder polymer which are preferred from the viewpoint of oxygen barrier performance include polyvinyl alcohol, partially saponified polyvinyl acetate, and polyamide. By selecting a binder polymer having oxygen barrier performance within a preferred range, it is possible to control the image reproducibility appropriately.

The thickness of the barrier layer is preferably 0.2 to 3.0 $\mu$m and further preferably 0.2 to 1.5 $\mu$m. If the thickness is smaller than the above-mentioned range, the oxygen barrier performance may become insufficient and the printing surface of a relief may be roughened. If the thickness is more than the above-mentioned range, the deterioration in reproducibility of a fine line may occur.

Although a method for producing the flexographic printing plate precursor of the present invention is not particularly limited, it may be produced generally as mentioned below.

Firstly, components of heat-sensitive mask layer (C) such as binder other than the carbon black are dissolved in a suitable solvent, and then the carbon black is dispersed therein so as to prepare a dispersion. Then the dispersion is applied onto a support for the heat-sensitive mask layer (such as a polyethylene terephthalate film). Then the solvent is evaporated therefrom. After that, a component for the oxygen barrier layer (D) is applied thereon whereupon one laminate is prepared. Further, apart therefrom, the photosensitive resin layer (B) is formed on another support (A) by means of application whereupon another laminate is prepared. The prepared two laminates are layered under pressurization and/or heating in such a manner that the photosensitive resin layer (B) adjacently contacts the oxygen barrier layer (D). Incidentally, after completion of the printing plate precursor, the support for the heat-sensitive mask layer functions as a protective film for a surface thereof.

Now, a method for producing a flexographic printing plate from this flexographic printing plate precursor produced as mentioned above will be explained. Firstly, the protective film (if any) is removed from the flexographic printing plate precursor. Thereafter, the heat-sensitive mask layer (C) is imagewise-irradiated with an IR laser so that a mask is formed on the photosensitive resin layer (B). Preferable examples of the IR laser include an ND/YAG laser (1064 nm) and a diode laser (for example, 830 nm). A laser system suitable for the Computer to Plate Technique is commercially available, and, for example, CDI (manufactured by Esko-Graphics Co., Ltd.) may be used. This laser system includes a rotation cylinder drum used for holding a printing plate precursor, an IR laser irradiating device and a layout computer. Pattern information is directly transferred from the layout computer to the laser device.

After the pattern information has been written in the heat-sensitive mask layer (C), the entire surface of the flexographic printing plate precursor is irradiated with active light rays via the imagewise-mask (main exposure). This process may be carried out with the plate attached to the laser cylinder; however, a method is generally used in which, after the plate has been removed from the laser device, the irradiation process is carried out by using a commonly-used irradiation unit having a flat plate shape because this method is more advantageous in that even a plate size out of the standard can be appropriately handled. Examples of the active light rays include: ultraviolet rays having an emission peak at a wavelength in a range from 330 to 380 nm. Examples of its light source include: a low-pressure mercury lamp, a highpressure mercury lamp, a super-high pressure mercury lamp, a metal halide lamp, a xenon lamp, a zirconium lamp, a carbon arc lamp and an ultraviolet-ray fluorescent lamp. Thereafter, the irradiated plate is developed, subjected to finishing exposure, and subjected to exposure with a germicidal lamp whereby the printing plate is obtained. The development step can be performed with a conventional development unit.

In a flexographic printing plate prepared as above, the composite elastic modulus of each dot can be 30 to 80 MPa, further 35 to 75 MPa, and further 40 to 70 MPa. The composite elastic modulus of each solid-printed part can be 5 to 15 MPa, further 6 to 14 MPa, and further 7 to 13 MPa. Due to these composite elastic modulus of each dot and composite elastic modulus of each solid-printed part, the flexographic printing plate of the present invention can achieve both of the reduction in dot gain of fine dots and satisfactory ink laydown on a solid-printed part.

The composite elastic modulus mentioned in the present invention was measured under the following measurement conditions using a nanoindentation device (Hysitron TI Premier) manufactured by Bruker. The calibration of the device was performed using quartz. The measurement was performed under the conditions where the value within the range of 69.6 ± 5% GPa can be obtained.

Indenter: a berkovich-type diamond indenter
Tip opening angle: 142.3°
Maximum Indentation depth: 4500 nm
Load speed, unload speed: 4500 nm/sec
Retention time: 0 sec
Feedback Mode: Displ. Control

The dynamic hardness measurement device DUH-201 which is used in Patent Documents 1 to 3 has a minimum testing force of 100 $\mu$N, while TI Premier has a minimum testing force of 75 nN. Therefore, TI Premier enables a highly accurate measurement. Due to this difference in stress sensing accuracy, TI Premier enables a highly accurate measurement compared with the measurement device used in Patent Documents 1 to 3.

A printing plate to be used in the measurement of a composite elastic modulus was produced under the following conditions. Back exposure, main exposure and finishing exposure were performed using TL-K 40W/10R lamp (peak wavelength: 370 nm, luminance at 350 nm: 10 mW/cm$^2$) manufactured by Philips. As to the germicidal lamp, a germicidal lamp GL-40 (peak wavelength: 250 nm, luminance at 250 nm: 4.5 mW/cm$^2$) manufactured by Panasonic Corporation. The imaging of the heat-sensitive mask layer was per formed using CDI 4850 manufactured by ESCO Graphics at a resolution of 4000 dpi. An image to be evaluated was one having at least dots (at 175 lpi, 0 to 10%) formed in 0.3% increments and an image having solid-printed parts. The amount of back exposure was adjusted to a time at which the relief depth could become 0.6 mm. The amount of main exposure was adjusted to a time at which 1% dots (diameter: 16 $\mu$m) was reproduced on the printing plate. After a development step and a subsequent drying step were performed, finishing exposure was performed for 7 minutes, and finally the plate was irradiated with a germicidal lamp for 5 minutes so as to prepare a printing plate.

A portion in which the diameter of each of dots was 25 $\mu$m was cut out from the printing plate produced under the above-mentioned printing plate production conditions, and was subjected to the measurement of a composite elastic modulus of each dot. The piece cut out from the printing plate was stored under the conditions of 25°C and 65% RH for 24 hours, and subsequently was subjected to the measurement of a composite elastic modulus. First, the position of an indenter was adjusted in such a manner that the indenter fell down at the center of each dot, then the indenter is pushed into a specimen, and a load-deflection curve was determined. The composite elastic modulus of each dot was calculated from the load-deflection curve in accordance with the following equation. In the equation, Er represents a composite elastic modulus, S represents contact stiffness, and Ac represents a contact area. In the fitting curve, the lower fit was set to 20%, and the upper fit was set to 95%. The measurement was performed 50 times, and an average of the measurement values was determined. The composite elastic modulus of each solid-printed part was determined by cutting out a solid-printed part from the printing plate produced under the above-mentioned printing plate production conditions, and was measured under the same measurement conditions as those employed for the measurement of the composite elastic modulus of each dot.

$$\text{Composite elastic modulus } Er = S\sqrt{\pi}/2\sqrt{Ac}$$

As shown in the equation, a composite elastic modulus is a parameter which also considers elastic deformation. In contrast, dynamic hardness which has been employed as an evaluation parameter of hardness in the prior art techniques is a parameter which does not consider elastic deformation.

In addition, from the viewpoint of measurement accuracy, a composite elastic modulus has an advantage that a further highly accurate measurement becomes possible compared with dynamic hardness, as explained above. This difference is caused from the difference in stress sensing accuracy of the devices used for these parameters.

Examples

As hereunder, the effects of the printing plate precursor of the present invention will be illustrated by referring to the following Examples although the present invention is not limited to those Examples. A term "part(s)" in Examples stand(s) for part(s) by mass. Values shown in Tables which indicate a composition ratio also stand for part(s) by mass.

Evaluation in Examples was done in accordance with the following methods.

(1) Composite elastic modulus

Using the flexographic printing plate produced in Example 1, a composite elastic modulus of each dot and a composite elastic modulus of each solid-printed part were calculated by the above-mentioned method using Hysitron TI Premier, manufactured by Bruker.

(2) Dot gain of fine dots

Using the flexographic printing plate produced in Example 1, dot gain of fine dots was evaluated using a flexographic printing machine FPR302 (manufactured by MCK Corporation) and using Anilox of 900LPI. As to the ink, an UV ink (product name: FLEXOCURE CYAN (manufactured by Flint)) was used. As to an object to be printed, coat paper (product name: Pearl Coat (manufactured by Oji Paper Co., Ltd.)) was used. The printing speed was 50 m/min. A position in which the printing plate contacted with the object to be printed was defined as zero. The indentation depth in printing was determined as a position at which the indenter was pushed into a depth of 90 $\mu$m from the zero position. Dots each having a dot size of 16 $\mu$m in diameter on the printing plate were focused, and the amount of dot enlargement during printing (dot gain) was measured with respect to the dots. A dot enlargement during printing (dot gain) of 5 $\mu$m or less was rated as "oo", a dot enlargement during printing (dot gain) of more than 5 and less than 10 $\mu$m was rated as "o", a dot enlargement during printing (dot gain) of 10 $\mu$m or more and less than 15 $\mu$m was rated as "Δ", and a dot enlargement during printing (dot gain) of 15 $\mu$m or more was rated as "×". A smaller numerical value of dot enlargement during printing (dot gain) means that the dot gain during printing was smaller and thus better printing was achieved.

(3) Ink laydown on the solid-printed part

The optical density of a solid-printed part on a printed matter which had been produced in the dot gain evaluation of fine dots was measured. The measurement of an optical density was performed using DM-800 manufactured by Dainippon Screen Mfg. Co., Ltd. A solid-printed part having an optical density of more than 1.7 was rated as "oo", a solid-printed part having an optical density of more than 1.6 and not more than 1.7 was rated as "o", a solid-printed part having an optical density of more than 1.5 and not more than 1.6 was rated as "Δ", and a solid-printed part having an optical density of not more than 1.5 was rated as "x". A larger optical density means that superior ink laydown on the solid-printed part was achieved.

(4) Reproducibility of isolated dot

The reproducibility of a minimum isolated dot on the printing plate was measured. A minimum isolated dot having a size of 50 $\mu$m or less was rated as "oo", a minimum isolated dot having a size of larger than 50 $\mu$m and not larger than 100 $\mu$m was rated as "o", a minimum isolated dot having a size of larger than 100 $\mu$m and not larger than 200 $\mu$m was rated as "Δ", and a minimum isolated dot having a size of larger than 200 $\mu$m was rated as "×". A smaller size of the reproduced minimum isolated dot means that the reproducibility of an isolated dot was superior.

(5) Durability of printing plate

The flexographic printing plate produced in Example 1 was subjected to printing at a length of 5,000 m by the same printing method as that employed in the dot gain evaluation of fine dots, except that the indentation depth was changed to 150 $\mu$m. Dots each having a diameter of 16 $\mu$m on the plate after the printing were observed with a microscope. A dot of which the appearance was not changed before and after the printing was rated as "oo", a dot which was slightly abraded only at an edge part was rated as "o", a dot which was partially lack or abraded was rated as "Δ", and a dot which was entirely lack or abraded was rated as "×".

Example 1

Preparation of photosensitive resin composition

A butadiene latex (Nipol LX111NF, non-volatile content: 55%, manufactured by Zeon Corporation) (86 parts by mass) that served as the polymer prepared by polymerizing a conjugated diene, an acrylonitrile-butadiene latex (Nipol SX1503, non-volatile content: 42%, manufactured by Zeon Corporation) (24 parts by mass) that served as the polymer prepared by polymerizing a conjugated diene, a polybutadiene-terminal acrylate having a number average molecular weight of 10000 (BAC45, manufactured by Osaka Organic Chemical Industry Ltd.) (15 parts by mass) that served as an ethylenically unsaturated compound, trimethylolpropane trimethacrylate having a number average molecular weight of 338 (Light Ester TMP, manufactured by Kyoeisha Chemical Co., Ltd.) (10 parts by mass) that served as ethylenically unsaturated compound, benzyl dimethylketal (3 parts by mass) that served as a photopolymerization initiator, and a hydrophilic polymer (PFT-4, non-volatile content: 25%, manufactured by Kyoeisha Chemical Co., Ltd.) (20 parts by mass), a butadiene oligomer (B2000, manufactured by Nippon Soda Co., Ltd.) (9.9 parts by mass), a thermal stabilizer (4-methoxyphenol) (0.1 part by mass), and an ultraviolet ray absorber (Tinuvin 326) (0.01 part by mass) that served as auxiliary components were mixed together in a container so as to produce a dope. The dope was charged into a pressurized kneader, and then the solvent was removed under a reduced pressure at 80°C so as to produce a photosensitive resin composition.

Preparation of flexographic printing plate precursor

Carbon black dispersion (AMBK-8 manufactured by ORIENT CHEMICAL INDUSTRIES CO., LTD.), copolymerized polyamide (PA223 manufactured by TOYOBO CO., LTD.), propylene glycol, and methanol were mixed at a mass proportion of 45/5/5/45 so as to obtain an heat-sensitive mask layer coating solution. After a releasing treatment was performed on both sides of a PET film (E5000 manufactured by TOYOBO CO., LTD., thickness: 100 $\mu$m), the heat-sensitive mask layer coating solution was applied onto the PET film using a bar coater so that a thickness of a coating film after being dried was 2 $\mu$m, and dried at 120°C for 5 minutes so as to obtain a film laminate (I). An optical density thereof was 2.3. The optical density was measured using a black-and-white transmission densitometer DM-520 (SCREEN Holdings Co., Ltd.). Polyvinyl acetate (KH20 manufactured by NIHON GOSEI KAKO Co., Ltd.) having a saponification degree of 80% and a plasticizer (glycerin) were mixed at a mass proportion of 70/30 so as to obtain an oxygen barrier layer coating solution. The oxygen barrier layer coating solution was applied onto the film laminate (I) using a bar coater so that a thickness of a coating film after being dried was 2.0 $\mu$m, and dried at 120°C for 5 minutes so as to obtain a film laminate (II). The photosensitive resin composition was disposed on a PET film support (E5000 manufactured by TOYOBO CO., LTD., thickness: 125 $\mu$m) coated with a copolymerized polyester-based adhesive, and the film laminate (II) was superposed on the photosensitive resin composition. These were laminated at 100°C using a heat pressing machine so as to obtain a flexographic printing plate precursor including a PET support, an adhesive layer, a photosensitive resin layer, an oxygen barrier layer, a heat-sensitive mask layer, and a cover film. A total thickness of the plate was 1.14 mm.

Preparation of printing plate from flexographic printing plate precursor

The printing plate precursor was subjected to back exposure from the PET support side for 10 seconds. Subsequently, the cover film was peeled off. This plate was wound around CDI4530 (manufactured by ESCO Graphics), and was then subjected to abrasion at a resolution of 4000dpi using a test image having dots (at 175 lpi, 0 to 10%, in 0.3% increment), isolated dots (between 0 to 300 $\mu$m, in 50 $\mu$m increment), and solid-printed parts. After the ablation, the plate was taken out, returned to the plane shape, and subjected to main exposure for 7 minutes. Thereafter, development was performed for 8 minutes using a developing machine (Stuck System, 1% aqueous washing soap solution, 40°C) manufactured by A & V Co., Ltd., and water droplets on the plate surface were removed with a drain stick. Thereafter, the plate was dried in a dryer at 60°C for 10 minutes, subjected to finishing exposure for 7 minutes, and finally irradiated with light from a germicidal lamp for 5 minutes, whereby a flexographic printing plate was thus obtained. The back exposure, main exposure and finishing exposure were performed using TL-K 40W/10R lamp (peak wavelength: 370 nm, luminance at 350 nm: 10 mW/cm$^2$) manufactured by Philips. As to the germicidal lamp, a germicidal lamp GL-40 (peak wavelength: 250 nm, luminance at 250 nm: 4.5 mW/cm$^2$) manufactured by Panasonic Corporation was used. It was confirmed that the relief depth of the resultant printing plate was 0.6 mm and dots each having a diameter of 16 $\mu$m were reproduced on the printing plate.

(Examples 2 to 15 and Comparative Examples 1 to 6)

Flexographic printing plate precursors were prepared in the same manner as in Example 1 except that the composition ratio of each component in the photosensitive resin composition constituting the photosensitive resin layer was changed as presented in Tables 1 and 2. The time of back exposure was adjusted so that the relief depth became 0.6 mm, and the time of main exposure was adjusted to a time at which dots each having a diameter of 16 $\mu$m were reproduced on the printing plate.

Evaluation results of Examples 1 to 15 and Comparative Examples 1 to 6 are shown in Tables 1 and 2.

[Table 1]

| | | | Examples | | | | |
|---|---|---|---|---|---|---|---|
| | | | 1 | 2 | 3 | 4 | 5 |
| Components of photosensitive resin layer (% by mass) | polymer prepared by polymerizing conjugated diene | butadiene polymer (LX111NF) | 47 | 43 | 43 | 47.5 | 44 |
| | | NBR polymer (SX1503A) | 10 | 10 | 7 | 10 | 10 |
| | ethylenically unsaturated compound | (meth)acrylate having low molecular weight (Light Ester TMP) | 10 | 10 | 13 | 10 | 13 |
| | | (meth)acrylate having low molecular weight (Light Ester 1,6 HX) | | | | | |
| | | (meth)acrylate having low molecular weight (Light Ester 19ND) | | | | | |
| | | acrylate having high molecular weight (BAC45) | 15 | 15 | 15 | 15 | 15 |
| | | (meth)acrylate having high molecular weight (TE2000) | | | | | |
| | photopolymerization initiator | benzyl dimethylketal | 3 | 5 | 7 | 2.5 | 3 |
| | | benzophenone | | | | | |
| | hydrophilic polymer | PFT4 | 5 | 5 | 5 | 5 | 5 |
| | plasticizer | butadiene oligomer (B2000) | 9.9 | 9.9 | 9.9 | 9.9 | 9.9 |
| | thermal polymerization inhibitor | 4-methoxyphenol | 0.1 | 0.1 | 0.1 | 0.1 | 0.1 |
| | ultraviolet ray absorber | Tinuvin 326 | 0.01 | 0.01 | 0.01 | 0.01 | 0.01 |
| Ratio of amount of photopolymerization initiat or / (meth)acrylate having low molecular weight | | | 0.30 | 0.50 | 0.54 | 0.25 | 0.23 |
| Oxygen barrier laver | | | present | present | present | present | present |
| Composite elastic modulus (Mpa) | | dot | 45 | 60 | 70 | 35 | 48 |
| | | solid-printed part | 12 | 13 | 14 | 11 | 13 |
| Evaluation results | | dot gain of fine dots | ∘ (7) | ∞ (5) | ∞ (4) | Δ (10) | ∘ (6) |
| | | ink laydown on solid-printed part | ∘ (1.65) | Δ (1.60) | Δ (1.58) | ∘ (1.67) | Δ (1.59) |
| | | reproducibility of isolated dot | ∘ (100) | ∘ (100) | ∘ (100) | ∘ (100) | ∘ (100) |
| | | durability of printing plate | ∘ | ∘ | ∘ | ∘ | ∘ |

EP 4 019 267 A1

12

(continued)

| | | 6 / 7 / 8 | 9 | 10 | | | |
|---|---|---|---|---|---|---|---|
| Components of photosensitive resin layer (% by mass) | polymer prepared by polymerizing conjugated diene | butadiene polymer (LX111NF) | 50 | 46.8 | 46.6 | 44 | 50 |
| | | NBR polymer (SX1503A) | 10 | 10 | 10 | 8 | 12 |
| | ethylenically unsaturated compound | (meth)acrylate having low molecular weight (Light Ester TMP) | 7 | 10 | 10 | 10 | 10 |
| | | (meth)acrylate having low molecular weight (Light Ester 1,6 HX) | | | | | |
| | | (meth)acrylate having low molecular weight (Light Ester 19ND) | | | | | |
| | | acrylate having high molecular weight (BAC45) | 15 | 15 | 15 | 20 | 10 |
| | | (meth)acrylate having high molecular weight (TE2000) | | | | | |
| | photopolymerization initiator | benzyl dimethylketal | 3 | 3 | 3 | 3 | 3 |
| | | benzophenone | | 0.2 | 0.4 | | |
| | hydrophilic polymer | PFT4 | 5 | 5 | 5 | 5 | 5 |
| | plasticizer | butadiene oligomer (B2000) | 9.9 | 9.9 | 9.9 | 9.9 | 9.9 |
| | thermal polymerization inhibitor | 4-methoxyphenol | 0.1 | 0.1 | 0.1 | 0.1 | 0.1 |
| | ultraviolet ray absorber | Tinuvin 326 | 0.01 | 0.01 | 0.01 | 0.01 | 0.01 |
| Ratio of amount of photopolymerization initiator / (meth)acrylate having low molecular weight | | | 0.43 | 0.32 | 0.34 | 0.30 | 0.30 |
| Oxygen barrier layer | | | present | present | present | present | present |
| Composite elastic modulus (Mpa) | | dot | 40 | 50 | 55 | 47 | 43 |
| | | solid-printed part | 9 | 12 | 12 | 12 | 10 |
| Evaluation results | | dot gain of fine dots | ∘ (8) | ∘ (6) | ∞ (5) | ∘ (7) | ∘ (8) |
| | | ink laydown on solid-printed part | ∘ (1.70) | ∘ (1.65) | ∘ (1.65) | ∘ (1.64) | ∘ (1.66) |
| | | reproducibility of isolated dot | ∘ (100) | ∘ (100) | ∘ (100) | ∞ (50) | Δ (150) |
| | | durability of printing plate | ∘ | ∘ | ∘ | ∞ | Δ |

| | | | 11 | 12 | 13 | 14 | 15 |
|---|---|---|---|---|---|---|---|
| Components of photosensitive resin layer (% by mass) | polymer prepared by polymerizing conjugated diene | butadiene polymer (LX111NF) | 47 | 47 | 47 | 59 | 47 |
| | | NBR polymer (SX1503A) | 10 | 10 | 10 | 13 | 10 |
| | ethylenically unsaturated compound | (meth)acrylate having low molecular weight (Light Ester TMP) | | | 10 | 10 | 10 |
| | | (meth)acrylate having low molecular weight (Light Ester 1,6 HX) | 10 | | | | |
| | | (meth)acrylate having low molecular weight (Light Ester 19ND) | | 10 | | | |
| | | acrylate having high molecular weight (BAC45) | 15 | 15 | | 0 | 15 |
| | | (meth)acrylate having high molecular weight (TE2000) | | | 15 | 0 | |
| | photopolymerization initiator | benzyl dimethylketal | 3 | 3 | 3 | 3 | 3 |
| | | benzophenone | | | | | |
| | hydrophilic polymer | PFT4 | 5 | 5 | 5 | 5 | 5 |
| | plasticizer | butadiene oligomer (B2000) | 9.9 | 9.9 | 9.9 | 9.9 | 9.9 |
| | thermal polymerization inhibitor | 4-methoxyphenol | 0.1 | 0.1 | 0.1 | 0.1 | 0.1 |
| | ultraviolet ray absorber | Tinuvin 326 | 0.01 | 0.01 | 0.01 | 0.01 | 0.01 |
| Ratio of amount of photopolymerization initiator / (meth)acrylate having low molecular weight | | | 0.30 | 0.30 | 0.30 | 0.30 | 0.30 |
| Oxygen barrier layer | | | present | present | present | present | absent |
| Composite elastic modulus (Mpa) | | dot | 45 | 42 | 45 | 40 | 32 |
| | | solid-printed part | 12 | 11 | 13 | 8 | 9 |
| Evaluation results | | dot gain of fine dots | ∘ (7) | ∘ (8) | ∘ (7) | ∘ (9) | Δ (12) |
| | | ink laydown on solid-printed part | ∘ (1.65) | ∘ (1.68) | ∘ (1.64) | ∘ (1.70) | Δ (1.60) |
| | | reproducibility of isolated dot | ∘ (100) | ∘ (100) | ∘ (100) | Δ (200) | ∘ (100) |
| | | durability of printing plate | ∘ | ∘ | ∘ | Δ | ∘ |

EP 4 019 267 A1

[Table 2]

| | | | Comparative Examples | | |
|---|---|---|---|---|---|
| | | | 1 | 2 | 3 |
| Components of photosensitive resin layer (% by mass) | polymer prepared by polymerizing conjugated diene | butadiene polymer (LX111NF) | 49 | 41 | 50.5 |
| | | NBR polymer (SX1503A) | 10 | 9 | 12 |
| | ethylenically unsaturated compound | (meth)acrylate having low molecular weight (Light Ester TMP) | 10 | 10 | 6 |
| | | (meth)acrylate having low molecular weight (Light Ester 1,6 HX) | | | |
| | | (meth)acrylate having low molecular weight (Light Ester 19ND) | | | |
| | | acrylate having high molecular weight (BAC45) | 15 | 15 | 15 |
| | | (meth)acrylate having high molecular weight (TE2000) | | | |
| | photopolymerization initiator | benzyl dimethylketal | 1 | 10 | 1.5 |
| | | benzophenone | | | |
| | hydrophilic polymer | PFT4 | 5 | 5 | 5 |
| | plasticizer | butadiene oligomer (B2000) | 9.9 | 9.9 | 9.9 |
| | thermal polymerization inhibitor | 4-methoxyphenol | 0.1 | 0.1 | 0.1 |
| | ultraviolet ray absorber | Tinuvin 326 | 0.01 | 0.01 | 0.01 |
| Ratio of amount of photopolymerization initiator / (meth)acrylate having low molecular weight | | | 0.10 | 1.00 | 0.25 |
| Oxygen barrier layer | | | present | 1.00 present | 0.25 present |
| Composite elastic modulus (Mpa) | | dot | 20 | 90 | 16 |
| | | solid-printed part | 10 | 18 | 8 |
| Evaluation results | | dot gain of fine dots | ✕ (16) | ∞ (4) | ✕ (17) |
| | | ink laydown on solid-printed part | ∘ (1.67) | ✕ (1.50) | ∘ (1.70) |
| | | reproducibility of isolated dot | ∘ (100) | ✕ (300) | ∘ (100) |
| | | durability of printing plate | ∘ | ✕ | ∘ |

(continued)

| | 4 | 5 | 6 | | | |
|---|---|---|---|---|---|---|
| Components of photosensitive resin layer (% by mass) | | polymer prepared by polymerizing conjugated diene | butadiene polymer (LX111NF) | 52 | 41 | 41 |
| | | | NBR polymer (SX1503A) | 12 | 8 | 11 |
| | | ethylenically unsaturated compound | (meth)acrylate having low molecular weight (Light Ester TMP) | 3 | 18 | 18 |
| | | | (meth)acrylate having low molecular weight (Light Ester 1,6 HX) | | | |
| | | | (meth)acrylate having low molecular weight (Light Ester 19ND) | | | |
| | | | acrylate having high molecular weight (BAC45) | 15 | 15 | 15 |
| | | | (meth)acrylate having high molecular weight (TE2000) | | | |
| | | photopolymerization initiator | benzyl dimethylketal | 3 | 3 | 5 |
| | | | benzophenone | | | |
| | | hydrophilic polymer | PFT4 | 5 | 5 | 5 |
| | | plasticizer | butadiene oligomer (B2000) | 9.9 | 9.9 | 9.9 |
| | | thermal polymerization inhibitor | 4-methoxyphenol | 0.1 | 0.1 | 0.1 |
| | | ultraviolet ray absorber | Tinuvin 326 | 0.01 | 0.01 | 0.01 |
| Ratio of amount of photo polymerization initiator / (meth)acrylate having low molecular weight | | | | 1.00 | 0.16 | 0.28 |
| Oxygen barrier laver | | | | present | present | present |
| Composite elastic modulus (Mpa) | | | dot | 25 | 85 | 87 |
| | | | solid-printed part | 7 | 23 | 25 |
| Evaluation results | | | dot gain of fine dots | ✕ (15) | ∞ (4) | ∞ (4) |
| | | | ink laydown on solid-printed part | ∞ (1.72) | ✕ (1.45) | ✕ (1.43) |
| | | | reproducibility of isolated dot | ○ (100) | ○ (100) | ○ (100) |
| | | | durability of printing plate | ○ | ○ | ○ |

Details of the ethylenically unsaturated compound in the above Tables are as follows.

Light Ester TMP: Trimethylolpropane tri(meth)acrylate, number average molecular weight: 338, manufactured by Kyoeisha Chemical Co., Ltd.

Light Ester 1,6 HX: 1,6-hexanediol dimethacrylate, number average molecular weight: 254, manufactured by Kyoeisha Chemical Co., Ltd.

Light Ester 19ND: 1,9-nonanediol di(meth)acrylate, number average molecular weight: 298, manufactured by Kyoeisha Chemical Co., Ltd.

BAC45: Polybutadiene-terminal acrylate, number average molecular weight: 10000, manufactured by Osaka Organic Chemical Industry Ltd.

TE2000: Polybutadiene having a methacrylate group introduced at terminal thereof, urethane-bonded type, number average molecular weight: 3,000, manufactured by Nippon Soda Co., Ltd.

As apparent from the above-shown evaluation results, in Examples 1 to 15 in each of which the composite elastic modulus of each dot and the composite elastic modulus of each solid-printed part respectively fell within the ranges defined in the present invention, both of the suppression of dot gain of fine dots and the ink laydown on solid-printed parts were achieved. As to the method for adjusting each of the composite elastic modulus of each dot and the composite elastic modulus of each solid-printed part to a value within the range defined in the present invention, it is critical that: the photopolymerization initiator is added in a larger amount compared with the conventional flexographic printing plate; a (meth)acrylate compound having a low molecular weight is added in a specified amount; and the ratio of the amount of the photopolymerization initiator to the amount of the (meth)acrylate compound having a low molecular weight is adjusted to a value within a specified range. In addition, by further adding a (meth)acrylate compound having a high molecular weight, even when the photopolymerization initiator is added in a larger amount, the reproducibility of isolated dots and the durability of a printing plate are not deteriorated (see the comparison between Examples 1 to 8, 11 to 13, and 15 with Examples 9, 10, and 14). Furthermore, by using benzophenone in combination with the photopolymerization initiator, the composite elastic modulus of each dot can be increased selectively (see the comparison between Examples 1 to 6 and 9 to 15 with Examples 7 and 8). Furthermore, by providing an oxygen barrier layer, the suppression of dot gain of fine dots and the ink laydown on solid-printed parts can be further improved (see the comparison between Examples 1 to 14 with Example 15).

In contrast, in Comparative Example 1, because the amount of the photopolymerization initiator added was small which was the same amount level as that employed conventionally, the composite elastic modulus of each dot was reduced and thus the dot gain of fine dots was not reduced. In Comparative Example 2, because the amount of the photopolymerization initiator added was large, the composite elastic modulus of each dot and the composite elastic modulus of each solid-printed part were high, whereby the ink laydown on the solid-printed parts was deteriorated, and the reproducibility of isolated dots and the durability of the printing plate were also deteriorated. In Comparative Example 3, because the amount of the photopolymerization initiator added was small, even when the ratio of the amount of the photopolymerization initiator to the amount of the (meth)acrylate compound having a low molecular weight was proper, the composite elastic modulus of each dot was reduced and thus the dot gain of fine dots was not reduced. In Comparative Example 4, because the amount of the (meth)acrylate compound having a low molecular weight added was small, the composite elastic modulus of each dot was reduced and thus the dot gain of fine dots was not reduced. In Comparative Example 5, because the amount of the (meth)acrylate compound having a low molecular weight added was large, the composite elastic modulus of each dot and the composite elastic modulus of each solid-printed part were high, whereby the ink laydown on the solid-printed parts was deteriorated. In Comparative Example 6, because the amount of the (meth)acrylate compound having a low molecular weight added was large, even when the ratio of the amount of the photopolymerization initiator to the amount of the (meth)acrylate compound having a low molecular weight was proper, the composite elastic modulus of each dot and the composite elastic modulus of each solid-printed part were high, whereby the ink laydown on the solid-printed parts was deteriorated.

Industrial Applicability

In the flexographic printing plate according to the present invention, the dot gain of fine dots can be reduced because the composite elastic modulus of each dot is adjusted to a specific higher value. In addition, in the flexographic printing plate according to the present invention, an ink laydown on a solid-printed part is excellent because the composite elastic modulus of the solid-printed part is adjusted to a specific lower value. Therefore, the flexographic printing plate according to the present invention can achieve both of the reduction in dot gain in fine dots and the satisfactory ink laydown on a solid-printed part. Therefore, the flexographic printing plate of the present invention is very useful in the industrial field.

**Claims**

1. A flexographic printing plate obtained from a flexographic printing plate precursor comprising at least a support (A), a photosensitive resin layer (B) and a heat-sensitive mask layer (C) which are laminated in this order, **characterized in that** the composite elastic modulus of each dot is 30 to 80 Mpa and the composite elastic modulus of each solid-printed part is 5 to 15 MPa.

2. The flexographic printing plate according to claim 1, wherein a photosensitive resin composition constituting the photosensitive resin layer (B) comprises (a) a polymer prepared by polymerizing a conjugated diene, (b) an ethylenically unsaturated compound and (c) a photopolymerization initiator, wherein the content of the photopolymerization initiator (c) in the photosensitive resin composition is 2 to 9% by mass, wherein the ethylenically unsaturated compound (b) includes a (meth)acrylate compound (i) having a number average molecular weight of 100 to 600, wherein the content of the (meth)acrylate compound (i) having a number average molecular weight of 100 to 600 in the photosensitive resin composition is 5 to 16% by mass, and wherein the ratio of the mass of the photopolymerization initiator (c) and the mass of the (meth)acrylate compound (i) having a number average molecular weight of 100 to 600 in the photosensitive resin composition is within the range of 0.20 to 0.55.

3. The flexographic printing plate according to claim 2, wherein the ethylenically unsaturated compound (b) further includes a (meth)acrylate compound (ii) having a number average molecular weight of more than 600 and not more than 20,000, and wherein the content of the (meth)acrylate compound (ii) having a number average molecular weight of more than 600 and not more than 20,000 in the photosensitive resin composition is 5 to 25% by mass.

4. The flexographic printing plate according to claim 2 or 3, wherein the photopolymerization initiator (c) includes two types of compounds which are a benzyl alkyl ketal compound and a benzophenone compound, and wherein the ratio of the mass of the benzyl alkyl ketal compound to the mass of the benzophenone compound is within the range of 99:1 to 80:20.

5. The flexographic printing plate according to any of claims 1 to 4, wherein the flexographic printing plate precursor has an oxygen barrier layer (D) between the photosensitive resin layer (B) and the heat-sensitive mask layer (C).

6. The flexographic printing plate according to any of claims 1 to 5, wherein the flexographic printing plate has been obtained by developing the flexographic printing plate precursor using a water-based developing solution.

7. A flexographic printing method, **characterized in that** the method uses the flexographic printing plate according to any of claims 1 to 6.

**INTERNATIONAL SEARCH REPORT**

| International application No. |
| --- |
| PCT/JP2020/025896 |

**A. CLASSIFICATION OF SUBJECT MATTER**
Int.Cl. B41N1/12(2006.01)i, B41C1/00(2006.01)i, B41M1/04(2006.01)i,
G03F7/00(2006.01)i, G03F7/027(2006.01)i, G03F7/031(2006.01)i,
G03F7/095(2006.01)i
FI: B41N1/12, B41M1/04, B41C1/00, G03F7/095, G03F7/027502, G03F7/031,
G03F7/00502
According to International Patent Classification (IPC) or to both national classification and IPC

**B. FIELDS SEARCHED**

Minimum documentation searched (classification system followed by classification symbols)
Int.Cl. B41N1/00-3/08, B41C1/00-3/08, B41M1/00-3/18, G03F7/00-7/18

Documentation searched other than minimum documentation to the extent that such documents are included in the fields searched
Published examined utility model applications of Japan     1922-1996
Published unexamined utility model applications of Japan     1971-2020
Registered utility model specifications of Japan     1996-2020
Published registered utility model applications of Japan     1994-2020

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | JP 2001-5173 A (TOYOBO CO., LTD.) 12.01.2001 (2001-01-12), paragraphs [0006]-[0039] | 1-7 |
| Y | JP 2019-95470 A (TOYOBO CO., LTD.) 20.06.2019 (2019-06-20), paragraphs [0046], [0047] | 1-7 |
| Y | JP 2018-91953 A (ASAHI KASEI CORPORATION) 14.06.2018 (2018-06-14), paragraphs [0002]-[0005] | 1-7 |
| A | WO 2015/191274 A1 (EASTMAN KODAK COMPANY) 17.12.2015 (2015-12-17), entire text, all drawings | 1-7 |

☐ Further documents are listed in the continuation of Box C.     ☒ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 18.09.2020 | 29.09.2020 |

| Name and mailing address of the ISA/ | Authorized officer |
| --- | --- |
| Japan Patent Office 3-4-3, Kasumigaseki, Chiyoda-ku, Tokyo 100-8915, Japan | Telephone No. |

Form PCT/ISA/210 (second sheet) (January 2015)

| INTERNATIONAL SEARCH REPORT | International application No. |
|---|---|
| Information on patent family members | PCT/JP2020/025896 |

| | | |
|---|---|---|
| JP 2001-5173 A | 12.01.2001 | US 6558870 B1<br>columns 1-12<br>EP 1063100 A2 |
| JP 2019-95470 A | 20.06.2019 | (Family: none) |
| JP 2018-91953 A | 14.06.2018 | (Family: none) |
| WO 2015/191274 A1 | 17.12.2015 | US 2015/0352834 A1<br>entire text, all drawings |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 9080743 A
- JP 2000221663 A
- JP 2002062639 A
- JP 607962 A
- JP 4200510 B
- JP 5710961 B
- JP 5525074 B